# EUROPÄISCHE PATENTSCHRIFT

(11) **EP 0 876 681 B1**
(45) Veröffentlichungstag und Bekanntmachung des Hinweises auf die Patenterteilung: **28.06.2000**
(21) Anmeldenummer: 96946149.0
(22) Anmeldetag: 18.12.1996
(51) Int. Cl.: H01L 29/788, G06G 7/60

(54) **HALBLEITERNEURON MIT VARIABLEN EINGANGSGEWICHTEN**
SEMICONDUCTOR NEURON WITH VARIABLE INPUT WEIGHTS
NEURONE A SEMI-CONDUCTEUR A POIDS D'ENTREE VARIABLES

(30) Priorität: 25.01.1996 DE 19602645
(43) Veröffentlichungstag der Anmeldung: 11.11.1998
(73) Patentinhaber: SIEMENS AKTIENGESELLSCHAFT, 80333 München (DE)
(72) Erfinder: THEWES, Roland, D-82194 Gröbenzell (DE); WEBER, Werner, D-80637 München (DE)
(86) Internationale Anmeldenummer: DE9602449
(87) Internationale Veröffentlichungsnummer: WO9727632

(56) Entgegenhaltungen:
- EP-A- 0 516 847
- EP-A- 0 657 934
- EP-A- 0 685 808

## Beschreibung

In der modernen Datenverarbeitung, insbesondere bei Video- und Audioanwendungen, spielen neuronale Netze eine zunehmende Rolle. Die Grundelemente dieser neuronalen Netze sind die Neuronen, bei denen im einfachsten Fall eine Anzahl von Eingängen mit variablem Gewicht auf einen einzigen Ausgang wirken, wobei dessen Signal jeweils einen anderen logischen Zustand annimmt, wenn die gewichtete Summe aller Eingänge eine bestimmte Schwelle über- bzw. unterschreitet. Neuronale Netze weisen gewisse Ähnlichkeiten mit Gehirnen auf, da sie insbesondere lernfähig sind und die Qualität ihres Ergebnisses stetig durch wiederholtes Üben verbessert werden kann. Heute werden Neuronen zumeist softwaremäßig realisiert. Für schnelle und komplexe Anwendungen neuronaler Netze ist jedoch in vielen Fällen eine hardwaremäßige Implementierung von Neuronen erforderlich, dies wies bisher jedoch Probleme bei der Adaptierbarkeit an verschiedene Anwendungen auf. Die weiter angestrebten Anwendungen, beispielsweise in der Bildverarbeitung, erfordern sehr hohe Verarbeitungsgeschwindigkeiten, die praktisch nur durch Hardwarelösungen erreichbar sind.

Aus den IEEE Transactions on Electron Devices, Vol. 39, No. 6, June 1992, Seiten 1444 bis 1454, ist bereits ein Bauelement bekannt, das bei sehr kleiner Fläche wichtige Teilfunktionen, wie zum Beispiel die Verknüpfung mehrerer Eingänge und eine Schwellwertbildung aufweist. Nachteilig ist hierbei, daß die einzelnen Eingänge nicht unterschiedlich gewichtet werden können bzw. daß die Gewichtung der Eingänge nicht flexibel änderbar ist.

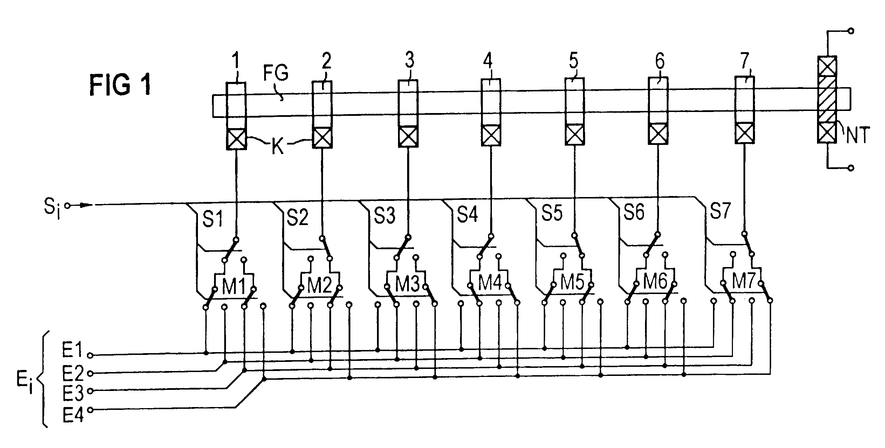

Aus den europäischen Patentanmeldungen 0 685 808 A und 0 657 934 A ist jeweils ein Halbleiterneuron bekannt, bei dem eine Mehrzahl von Teilelektroden bestehende Eingangselektrode zur Signalübertragung kapazitiv mit einem Floating-Gate gekoppelt ist, wobei die Eingänge des Halbleiterneurons mit mehreren Teilelektroden verbunden sein können, damit die Gesamtfläche dieser Eingänge die Gewichte aller Neuroneingänge geändert werden können. Zum Beispiel ist in Figur 8 der ersten Anmeldung der Eingang Ci-1 mit zwei Elektroden der zwei letzten Stufen angeschlossen während die zwei anderen Signaleingänge nur jeweils mit einer Elektrode angeschlossen sind. Zum Beispiel sind in Figur 1c der zweiten Anmeldung die Eingangselektroden A1 - A3 miteinander verbunden, während die Eingangselektroden C1 - C4 miteinander verbunden sind.

Der Erfindung liegt nun die Aufgabe zugrunde, ein Halbleiterneuron und eine entsprechende Ansteuerung so anzugeben, daß das Halbleiterneuron bei kleiner Chipfläche und hoher Verarbeitungsgeschwindigkeit eine variable Gewichtung der Eingänge ermöglicht.

Diese Aufgabe wird erfindungsgemäß durch die Merkmale des Patentanspruchs 1 gelöst. Die Unteransprüche betreffen vorteilhafte Ausgestaltungen der Erfindung.

Die Erfindung wird nachfolgend anhand der Zeichnungen näher erläutert. Dabei zeigt
- Figur 1: ein Blockschaltbild des erfindungsgemäßen Halbleiterneurons und
- Figur 2: ein Blockschaltbild einer Schaltung mit mehreren erfindungsgemäßen Halbleiterneuronen und Steuerschaltungen sowie weiterer Peripherie und
- Figur 3: ein Schaltbild einer Steuerschaltung von Figur 2.

In Figur 1 ist ein Blockschaltbild eines erfindungsgemäßen Halbleiterneurons gezeigt, das einen MOS-Feldeffekttransistor NT mit einem Floating Gate FG aufweist, wobei das Floating Gate eine gemeinsame Gegenelektrode von Eingangskapazitäten darstellt, die jeweils durch die Gegenelektrode und jeweilige Teilelektroden 1 ... 7 gebildet werden. Die Zahl der Teilelektroden kann hierbei praktisch beliebig gewählt werden. Das Floating Gate ist dabei beispielsweise aus einer ersten Polysiliziumschicht gebildet, die gegenüber einem Halbleitersubstrat und gegenüber den Teilelektroden durch eine Oxidschicht elektrisch isoliert ist. Die Teilelektroden können dabei in einer zweiten darüberliegenden Polysiliziumschicht gefertigt und über Kontaktlöcher K elektrisch kontaktiert sein. Eine jeweilige Teilelektrode 1 ... 7 ist mit einem Ausgang eines jeweiligen zugehörigen Multiplexers M1 ... M7 verbunden. Die Eingänge eines jeden Multiplexers sind mit Neuroneingängen Eᵢ bzw. E1 ... E4 beschaltet und der jeweilige Multiplexer verbindet jeweils immer genau einen Neuroneingang mit einer Teilelektrode. Die Anzahl der Eingänge kann praktisch beliebig sein, ist jedoch sinnvollerweise wesentlich kleiner als die Anzahl der Teilelektroden. Die Multiplexer M1 ... M7 werden von Steuersignalen Sᵢ bzw. S1 ... S7 angesteuert, die in einer Steuerschaltungen gebildet werden und die je nach der Zahl der Neuroneingänge ein aber auch mehrere Bit breit sein können.

Bei dem in Figur 1 gezeigten Beispiel sind sieben Teilelektroden und vier Neuroneingänge E1..E4 vorgesehen, wobei über die Multiplexer M1 ... M7 die Elektroden 1 und 6 mit dem Neuroneingang E1, die Elektroden 2 und 5 mit dem Neuroneingang E3, die Elektroden 3 und 4 mit dem Neuroneingang E2 und die einzelne Eingangselektrode 7 mit dem Neuroneingang E4 verbunden sind. Dies hat zur Folge, daß, sofern die Elektroden 1 ...7 alle die gleiche Fläche haben, die Neuroneingänge E1, E2 und E3 gegenüber dem Neuroneingang E4 mit doppeltem Gewicht bewertet werden, da bezüglich dieser Neuroneingänge die Kondensatorflächen und damit die Koppelkapazität gegenüber der Koppelkapazität des Neuroneingangs E4 verdoppelt ist.

Die einzelnen Elektroden können aber auch selbst unterschiedliche Abmessungen und damit von vornherein unterschiedliches Gewicht haben. Wenn zum Beispiel die Gewichte der Eingangselektroden 1..3 das Gewicht 1, die Eingangselektroden 4 und 5 das Gewicht 2, die Eingangselektrode 6 das Gewicht 3 und die Eingangselektrode 7 das Gewicht 4 aufweisen, so ist eine feinere Abstufung bezüglich der Verteilung der Gewichte auf die Eingänge möglich als bei einer Anordnung mit gleichen Elektrodenabmessungen. Mit der angegebenen Verteilung der Gewichte der Eingangselektroden und der Schalterstellung der Multiplexer gemäß Figur 1 erhält der Eingang E1 nun das Gewicht 1+3=4, der Eingang E2 das Gewicht 1+2=3, der Eingang E3 das gewicht 1+2=3 und der Eingang E4 das Gewicht 4.

Um die vorhandene Hardware voll zu nutzen ist es von Vorteil, wenn jeweils die Gesamtfläche aller gerade mit Neuroneingängen verbundenen Teilelektroden, bei beliebiger Gewichtung der Neuroneingänge, stets so groß wie die Gesamtfläche aller überhaupt vorhandenen Teilelektroden ist.

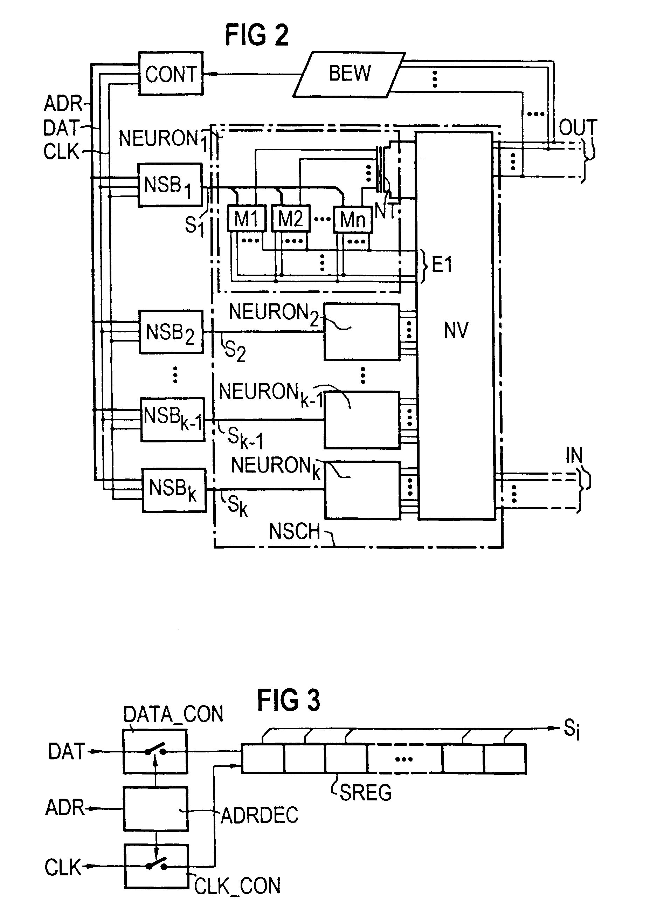

Figur 2 zeigt beispielhaft eine schematische Darstellung einer Neuron-Schaltung NSCH mit k Neuronen NEURON₁ ... NEURONₖ. Diese Neuronen sind untereinander über ein Netzwerk NV vernetzt, welches auch Eingangssignale IN und Ausgangssignale OUT der Neuron-Schaltung NSCH in der gewünschten Form mit den Neuronen verbindet. Außerhalb der signalverarbeitenden Neuron-Schaltung NSCH befinden sich k Steuerschaltungen NSB₁ ... NSBₖ zur Bildung von Steuersignalen S₁..Sₖ zur Steuerung der Multiplexer der jeweiligen Neuronen, wobei die Neuronen der Schaltung NSCH bezüglich der Anzahl ihrer Eingänge, der Anzahl ihrer Eingangselektroden bzw. der Anzahl ihrer Multiplexer und der Aufteilung der verfügbaren Gewichte nicht notwendigerweise identisch konfiguriert sein müssen. Die Steuerschaltungen NSB₁ ... NSBₖ sind mit einem einzelnen Controller CONT verbunden, wobei jede der Steuerschaltungen über eine eigene Adresse ADR vom Controller einzeln ansprechbar ist und wobei der jeweilig adressierten Steuerschaltung Daten DAT zur Einstellung der Multiplexer M1 ... Mn des jeweiligen Neurons übermittelbar sind.

Zur Erläuterung der Funktionsweise wird zunächst davon ausgegangen, daß alle Neuronen der Schaltung NSCH einen bestimmten Zustand bezüglich der Verteilung der Gewichte der Teilelektroden auf die Eingänge besitzen. Dieser Zustand, sowie auch die Konfiguration aller Neuronen, das heißt die Zahl ihrer Eingangselektroden mitsamt den dazugehörigen Gewichten sowie die Zahl der Eingänge sind dem Controller CONT bekannt. Während der Lernphase der Neuron-Schaltung NSCH erzeugt die Neuron-Schaltung NSCH bei Anlegen eines bestimmten Eingangssignales IN ein Ausgangssignal OUT. Dieses Ausgangssignal OUT wird von einer Bewertereinheit BEW bewertet, wobei diese Bewertereinheit hardwaremäßig auf dem gleichen Chip realisiert sein kann, was jedoch nicht zwingend notwendig ist. Die Bewertereinheit teilt das Ergebnis der Bewertung des Ausgangssignales dem Controller CONT mit. Im Falle eines nicht zufriedenstellenden Ergebnisses berechnet dieser aufgrund seiner Kenntnis des Zustandes und der Konfiguration der Neuronen einen neuen Zustand und gibt die erforderlichen Daten an die Steuerschaltungen NSB₁ ... NSBₖ weiter. Vorteilhaft an dieser Ausgestaltung der Gesamtschaltung aus der Neuron-Schaltung NSCH, dem Controller CONT und den Steuerschaltungen NSB ist, daß, wie in Figur 3 gezeigt, eine Steuerschaltung NSB mit verhältnismäßig geringem Aufwand und Platzbedarf realisierbar ist und daß nur an einer Stelle der Gesamtschaltung eine einzige zentrale, intelligente Einheit zur Berechnung der einzustellenden Zustände der Neuronen, nämlich der Controller CONT erforderlich ist.

In Figur 3 ist beispielhaft eine Steuerschaltung mit einem Adressdecoder ADRDEC, einer Datenverbindungseinheit DATA_CON, einer Taktverbindungseinheit CLK_CON und einem Schieberegister SREG mit Haltegliedern (Latches) gezeigt, wobei abhängig von der Adresse ADR die Daten DAT und ein vom Controller CONT kommendes Taktsignal CLK dem Schieberegister zuführbar sind, welches seinerseits die Steuersignale Sᵢ für die Multiplexer eines jeweiligen Neurons erzeugt. Die Anzahl der Stufen und damit auch die Anzahl der Ausgänge des Schieberegisters ist gleich der Anzahl der Bits, die zur vollständigen Steuerung der Multiplexer eines Neurons nötig sind. Die parallelen Ausgänge des Schieberegisters bilden die Ansteuersignale für die Multiplexer eines Neurons.

Im Falle des Neurons gemäß Figur 1 wäre also ein 14-stufiges Schieberegister nötig. Um die einzelnen Stufen des Schieberegisters mit Daten zu beschreiben, müssen an einen lBit breiten Dateneingang des Schieberegisters ein Datum angelegt werden, welches bei Triggerung durch das Taktsignal CLK in die erste Stufe übernommen wird. Bei einer weiteren Triggerung des Schieberegisters wird dieses Datum in die folgende Stufe übernommen, während die erste Stufe das aktuell am Dateneingang verfügbare Datum einliest usw.

Daten- und Takteingang eines jeweils zu einer Steuerschaltung NSB gehörenden Schieberegisters werden jedoch nur dann freigegeben, sofern der Controller CONT die Adresse auf der Adreßleitung ausgewählt hat, die mit der Adresse des Adressdecoders der entsprechenden Schaltung NSB übereinstimmt. Vorteilhaft an einem solchen Aufbau einer Steuerschaltung NSB ist zum einen, daß sich der schaltungstechnische Aufwand in vertretbaren Grenzen hält, und daß andererseits eine nicht allzu große Anzahl an Leitungen zur Verbindung des Controllers CONT mit den Steuerschaltungen NSB₁ ... NSBₖ vonnöten ist.

## Patentansprüche

1. Halbleiterneuron,
bei dem mindestens eine aus einer Mehrzahl von Teilelektroden (1 ... 7) bestehende Eingangselektrode zur Signalübertragung kapazitiv mit einem Floating Gate (FG) gekoppelt ist, dessen Potential den Strom eines MOS-Feldeffekttransistors (NT) steuert, und
bei dem ein jeweiliger Neuroneingang (E1 ... E4) mit Teilelektroden aus der Mehrzahl von Teilelektroden (1 ... 7) derart verbindbar ist, daß die Gesamtfläche der mit dem jeweiligen Neuroneingang verbundenen Teilelektroden einem jeweiligen Gewicht des Neuroneingangs entspricht, gekennzeichnet dadurch daß die Teilelektroden (1 ...7) der Eingangselektroden über Multiplexer (M1 ...M7) mit Neuroneingängen (Eᵢ) verbunden sind.

2. Halbleiterneuron nach Anspruch 1,
bei dem Teilelektroden (1 ... 7) eines jeweiligen Neurons unterschiedlich große Elektrodenflächen aufweisen.

3. Halbleiterneuron nach Anpruch 1,
bei dem ein jeweiliges Neuron (N₁ ... Nₖ) durch eine jeweilige Steuerschaltung (NSB₁ ..NSBₖ) angesteuert sind, wobei alle Steuerschaltungen von einem einzelnen Controller (CONT) mit Adressen (ADR), Daten (DAT) und einem Taktsignal (CLK) versorgt sind.

4. Halbleiterneuron nach Anspruch 3,
bei dem eine mit einem jeweiligen Neuron verbundene jeweilige Steuerschaltung mit einem Adressdecoder (ADRDEC), einer Datenverbindungseinheit (DATA_CON), einer Taktverbindungseinheit (CLK_CON) und einem Schieberegister (SREG) ausgestattet ist, wobei abhängig von der Adresse (ADR) die Daten (DAT) und das Taktsignal (CLK) dem Schieberegister zuführbar sind, welches seinerseits Steuersignale (Sᵢ) für die Multiplexer eines jeweiligen Neurons erzeugt.

5. Halbleiterneuron nach Anspruch 3 oder 4,
bei dem die jeweilige Steuerschaltung vom Controller derart mit Adressen und Daten versorgt wird, daß die Gesamtfläche aller mit Neuroneingängen verbundenen Teilelektroden eines jeweiligen Neurons, bei beliebiger Gewichtung der Neuroneingänge, stets so groß wie die Gesamtfläche aller Teilelektroden des jeweiligen Neurons ist.

## Claims

1. Semiconductor neuron, in which at least one input electrode, consisting of a plurality of partial electrodes (1 ... 7) is coupled capacitively for signal transmission to a floating gate (FG) whose potential controls the current of a MOS field effect transistor (NT), and in which a respective neuron input (E1 ... E4) can be connected to partial electrodes of the plurality of partial electrodes (1 ... 7) in such a way that the total surface area of the partial electrodes connected to the respective neuron input corresponds to a respective weight of the neuron input, characterized in that the partial electrodes (1 ... 7) of the input electrodes are connected via multiplexers (M1 ... M7) to neuron inputs (Eᵢ).

2. Semiconductor neuron according to Claim 1, in which partial electrodes (1 ... 7) of a respective neuron have different electrode surface areas.

3. Semiconductor neuron according to Claim 1, in which a respective neuron (N₁ ... Nₖ) is driven by a respective control circuit (NSB₁ .. NSBₖ), all control circuits being supplied from a single controller (CONT) with addresses (ADR), data (DAT) and a clock signal (CLK).

4. Semiconductor neuron according to Claim 3, in which a respective control circuit connected to a respective neuron is equipped with an address decoder (ADRDEC), a data connection unit (DATA_CON), a clock connection unit (CLK_CON) and a shift register (SREG), it being possible for the data (DAT) and the clock signal (CLK) to be fed as a function of the address (ADR) to the shift register which, for its part, produces control signals (Sᵢ) for the multiplexers of a respective neuron.

5. Semiconductor neuron according to Claim 3 or 4, in which the respective control circuit is supplied by the controller with addresses and data in such a way that the total surface area of all partial electrodes connected to neuron inputs of a respective neuron is, for arbitrary weighting of the neuron inputs, always the same size as the total surface area of all partial electrodes of the respective neuron.

## Revendications

1. Neurone à semi-conducteur, dans lequel au moins une électrode d'entrée formée de plusieurs électrodes partielles (1 ... 7) est couplée de manière capacitive, pour la transmission de signaux, à une grille flottante (FG) dont le potentiel commande le courant d'un transistor à effet de champ MOS (NT), et dans lequel une entrée de neurone respective (E1 ... E4) peut être connectée à des électrodes partielles parmi la pluralité d'électrodes partielles (1 ... 7), de manière à ce que la surface totale des électrodes partielles connectées à l'entrée de neurone respective corresponde à un poids respectif de l'entrée de neurone, caractérisé en ce que les électrodes partielles (1 ... 7) des électrodes d'entrée sont connectées aux entrées de neurone (Eᵢ) par le biais de multiplexeurs (M1 ... M7).

2. Neurone à semi-conducteur selon la revendication 1, dans lequel les électrodes partielles (1 ... 7) d'un neurone respectif ont des surfaces d'électrode de dimensions différentes.

3. Neurone à semi-conducteur selon la revendication 1, dans lequel un neurone respectif (N₁ ... Nₖ) est commandé par un circuit de commande respectif (NSB₁ ... NSBₖ), un contrôleur unique (CONT) fournissant des adresses (ADR), des données (DAT) et un signal d'horloge (CLK) à tous les circuits de commande.

4. Neurone à semi-conducteur selon la revendication 3, dans lequel un circuit de commande respectif relié à un neurone respectif est équipé d'un décodeur d'adresse (ADRDEC), d'une unité de liaison de données (DATA-CON), d'une unité de liaison de synchronisation (CLK-CON) et d'un registre à décalage (SREG), les données (DAT) et le signal d'horloge (CLK) pouvant, en fonction de l'adresse (ADR), être amenés au registre à décalage qui, de son côté, produit des signaux de commande (Sᵢ) pour les multiplexeurs d'un neurone respectif.

5. Neurone à semi-conducteur selon la revendication 3 ou 4, dans lequel le contrôleur fournit des adresses et des données au circuit de commande respectif, de manière à ce que la surface totale de toutes les électrodes partielles d'un neurone respectif connectées aux entrées de neurone soit toujours aussi grande que la surface totale de toutes les électrodes partielles du neurone respectif, quelle que soit la pondération des entrées de neurone.
